# EUROPÄISCHE PATENTSCHRIFT

(11) **EP 1 640 481 B1**
(45) Veröffentlichungstag und Bekanntmachung des Hinweises auf die Patenterteilung: **03.01.2007**
(21) Anmeldenummer: 05018979.4
(22) Anmeldetag: 01.09.2005
(51) Int. Cl.: C30B 25/12, C23C 14/50, C23C 16/458

(54) **Drehbarer Substrathalter**
rotatable substrate holder
porte-substrat rotative

(30) Priorität: 23.09.2004 DE 102004046280
(43) Veröffentlichungstag der Anmeldung: 29.03.2006
(73) Patentinhaber: Forschungszentrum Karlsruhe GmbH, 76133 Karlsruhe (DE)
(72) Erfinder: Geerk, Jochen, Dr., 76356 Weingarten (DE); Ratzel, Fritz, 76351 Linkenheim-Hochstetten (DE); Schneider, Rudolf, Dr., 76676 Graben-Neudorf (DE)

(56) Entgegenhaltungen:
- US-A- 5 618 388
- US-A1- 2003 096 711
- US-B1- 6 572 936
- PATENT ABSTRACTS OF JAPAN Bd. 018, Nr. 415 (C-1233), 4. August 1994 (1994-08-04) & JP 06 122972 A (NIKON CORP), 6. Mai 1994 (1994-05-06)

## Beschreibung

Die Erfindung betrifft einen drehbaren Substrathalter in einer Einrichtung zum Beschichten eines Substrats mit einer dünnen, mehrkomponentigen, metallischen Dünnschicht unter Vakuumbedingungen. Die auf dem Substrat aufgebrachte Dünnschicht besteht aus mindestens zwei, sich hinsichtlich ihres Dampfdruckes unterscheidenden Beschichtungskomponenten/Elementen, Legierungen oder Verbindungen.

Die Einrichtung zum Beschichten ist Bestandteil einer Anlage, die aus drei Baugruppen besteht und in einem evakuierbaren Gefäß untergebracht ist. Die Baugruppen sind:
eine elektrisch beheiz- und thermostatisierbare Dampfquelle zum Verdampfen der Komponente mit dem höheren Dampfdruck,
eine Zerstäubungs-/Sputterquelle über dem Substrat zur Erzeugung eines auf das Substrat gerichteten, atomaren Targetmaterialstrahls aus der Komponente mit dem niedrigeren Dampfdruck und
die beheiz- und thermostatisierbare Einrichtung zum Exponieren des Substrats für die Beschichtung, welches auf dem drehbaren Substrathalter festgemacht ist.

Mit einer solchen Anlage werden dünne Schichten, meist Metallschichten, in einem kombinatorischen Verfahren über Zerstäuben/Sputtern, z. B. Kathodenzerstäubung, und Aufdampfen auf dem Substrat in einem Prozessvakuum hergestellt. Der Aufbau der Anlage u. a. aus Dampfquelle und Zerstäubungsquelle wird gewählt, um insbesondere den höheren wärmetechnischen Aufwand für die Quelle zur Freisetzung der Komponente mit dem niedrigeren Dampfdruck zu vermeiden. Ein Aufbau mit je einer Dampfquelle pro Komponenten ist prinzipiell möglich aber wärmetechnisch aufwendiger.

Aus der DE 103 41 914 ist ein beheizbarer Substrathalter zu entnehmen, der drehbar gelagert ist und gleichzeitig zu einer Dampfquelle als auch zu einer Zerstäubungs-/Sputterquelle hin ausgerichtet ist. Das Substrat ist somit gleichzeitig dem Metalldampf mit hohem Dampfdruck und der Zerstäubungswolke aus der Komponente mit niedrigem Dampfdruck ausgesetzt. Das ist für den Langzeitbetrieb und damit eine industrielle Beschichtungstechnik ungeeignet, weil sich die Emissionsfläche der Zerstäubungseinrichtung in kurzer Zeit mit der Komponente mit dem hohen Dampfdruck zusetzt und damit ausfällt.

Der Erfindung liegt die Aufgabe zugrunde, Komponentenquellen einer Einrichtung zur Beschichtung eines Substrats mit einer mehrkomponentigen Dünnschicht räumlich derart voneinander trennen zu können, dass sich die Quellen nicht mehr gegenseitig durch unerwünschte Beschichtung beeinträchtigen und damit außer Funktion setzen können.

Die Erfindung wird durch einen drehbaren Substrathalter, aufgebaut gemäß den Merkmalen des Anspruchs 1, gelöst. Der Substrathalter besteht aus einer Welle aus wärmebeständigem und gut wärmeleitendem Material. Häufig ist das ein wärmebeständiger Edelstahl, der noch bis mindestens 800°C Betriebstemperatur formbeständig und mechanisch belastbar ist. Andere Materialien kommen ebenfalls in Betracht, wenn sie die Betriebsbedingungen erfüllen, insbesondere hinsichtlich chemisch inerten Verhaltens und thermischer als auch mechanischer Formstabilität.

Auf der Welle sitzt koaxial der kreiszylindrische Körper, zweckmäßigerweise aus demselben Material lösbar, mittig fest. Der Körper hat an seinen beiden Endbereichen koaxial je mindestens einen ringscheibenförmigen Einstich (siehe unten). An seiner Mantelwand ist zwischen den links und rechtsseitigen Einstichen die achsparallele, kreissehnenebene Ausnehmung für die Aufnahme und Exposition des zu beschichtenden Substrats. Diese Ausnehmung ist im Betrieb kontinuierlich oder schrittweise durch einen außerhalb an der Vakuumanlage sitzenden Antriebsmotor über eine vakuumdurchgeführte Antriebswelle von der völligen Exposition zur Dampfquelle hin über die völlige Verdeckung zur völligen Exposition zur Zerstäubungseinrichtung hin über die völlige Verdeckung voll drehbar, in die eine als auch in die andre Richtung. Außerhalb der beiden Exponierpositionen, Bedampfung und Bestäubung, ist der Körper zumindest im Bereich der links- und rechtsseitigen Einstiche völlig von seinem Lagerkörper in der Beschichtungseinrichtung berührungslos unter immer noch schmaler Spaltbildung bei der höchsten Betriebstemperatur umgeben. Für die eventuell noch minimalen Materialströme aus den Beschichtungskomponenten durch den kreiszylindrischen Spalt zwischen Lagergehäuse und kreiszylindrischem Körper bilden diese ringscheibenförmigen Schlitze Fallen oder Wegverlängerungen.

An den beiden planen Stirnflächen des Körpers liegt je ein ringförmiges Gleitlager aus wärmebeständigem, schlecht wärmeleitendem Material gleitfähig an. (Keramik ist dazu gut geeignet, siehe unten.). Beide Gleitlager gleiten mit ihrer inneren Mantelfläche auf der Welle des Substrathalters und mit ihrer äußeren Mantelfläche am Lagerkörper/-gehäuse. Um das sichere Gleiten bei allen Betriebstemperaturen zu gewährleisten, liegt an der äußeren und/oder inneren Mantelfläche ein Band aus dem Material der Welle des Substrathalters oder des Lagergehäuses an, das meist das gleiche ist. Bei den Betriebstemperaturen, die komponentenabhängig festgelegt wird, eignet sich formstabiler Edelstahl. Das Band liegt zwar formschlüssig an, sitzt aber lösbar an der Mantelwand. Es soll sich längs dehnen können und ist deshalb an einer Stelle schlitzartig unterbrochen, so dass sich seine beiden Stirnseiten bei der höchsten Betriebstemperatur, gleichbedeutend mit der größten Längenausdehnung des Bandes, immer noch nicht berühren/stoßen und damit Zum Ausweichen stellenweise vom schlecht wärmeleitenden Lagerring abdrücken, um so erst recht eine Blockierung hervorzurufen. Der Zweck des Bandes ist das sichere Drehen des Substrathalters bei allen Betriebstemperaturen und muss es sein. Durch diese Maßnahme wird ein Blockieren während der Drehung vermieden. Das Band gleitet bei Formschluss an der Welle als auch an dem Lagergehäuse ohne zu fressen. Dies ist eine experimentelle Erfahrung. Unterschiedliches Wärmeverhalten der Welle, des Lagergehäuses und des rinförmigen Lagerkörpers selber wird so neutralisiert, ohne den vorgesehenen Betrieb, die gesteuerte Drehung des Substrathalters, zu beeinträchtigen.

Eine Heizung ist dem Lagerkörper übergestülpt, durch die hindurch zwar ein Zugang/Durchgang zu der Welle des Substrathalters besteht, die aber auch den Substrathalter durch ihre Umhüllung axial mit Spiel in Position hält.

Die Unteransprüche 2 bis 4 spezifizieren die Merkmale aus dem Hauptanspruch. So bestehen nach Anspruch 2 die beiden Gleitlagerringe des drehbaren Substrathalters aus einem wärmebeständigen Glas oder aus einer wärmebeständigen Keramik oder einer anderen, für solche Prozesstemperaturen und mechanischen Anforderungen geeignete Materialien. Als ein solches wärmebeständiges Glas eignet sich Quarzglas vorzugsweise, als wärmebeständige Keramik A1203.

Für die geführte Drehung des Substarthalters hat sich nach Anspruch 3 einerseits bewährt, dass die Welle hohl ist, von der Innenwand der kreiszylindrischen Hülse ein Stift radial nach innen ragt oder ein Stift über die lichte Weite sitzt, an welchem eine herangeführte Antriebeswelle ankoppelt. Andrerseits ist die konstruktive Maßnahme nach Anspruch 4, dass die Welle massiv ist und zumindest an einer Stirnseite eine Eingriffsstruktur für eine herangeführte Antriebswelle hat, ebenfalls einfach und für eine zuverlässige Kopplung geeignet.

In der Einrichtung zur Beschichtung wird der Substrathalter über die an oder in seiner Welle steckbare Antriebswelle, welche eine gesteuerte Antriebsmotordrehung überträgt, gedreht. Der Substrathalter kann so kontinuierlich oder im Schritt oder von Position zu Position in die eine oder andere Richtung gedreht werden. Der Substrathalter ist in dem Block, dem Lagergehäuse, aus bis mindestens 800°C wärmebeständigem und gut wärmeleitfähigem Material, wie der Vorratsbehälter der Dampfquelle, aus Edelstahl beispielsweise, gelagert. Der Block sitzt über der Öffnung des Vorratsbehälters über eine geringe Berührfläche auf, um den Wärmeübergang vom Vorratsbehälter, der eine deutlich höhere Temperatur hat als der Block, zu unterdrücken oder für den Beschichtungsprozess unerheblich zu halten. Zur Fixierung kann der Block über Schraubverbindungen mit dem Vorratsbehälter verbunden sein.

Das Lagergehäuse hat einen zentralen, vertikal verlaufenden Durchgangsbereich und eine horizontale, den vertikalen Durchgangsbereich zentral kreuzende Durchgangsbohrung. In dieser Durchgangsbohrung sitzt der zylindrische Substrathalter über seine beiden Gleitringlager drehbar gelagert. Mittig hat der Substrathalter die kreissehnenebene Ausfräsung zum Einlegen und Befestigen des zu beschichtenden Substrats. Die Ausfräsung ist so angebracht, dass sie bei entsprechender Drehung des Substrathalters zum vertikalen Durchgangsbereich vollständig exponiert werden kann und somit das beispielsweise über Silberlot befestigte Substrat dem Metalldampf aus dem Vorratsbehälter/der Dampfquelle in der Position nach unten aber auch dem gerichteten Materialfluss von der Sputtereinrichtung in der Position nach oben hindernisfrei ausgesetzt ist. Die lichte Weite des vertikalen Durchgangsbereichs ist mindestens so groß wie die größte Ausdehnung des Substrats; für eine eventuell auch schräge, immer noch völlige Exposition des Substrats noch größer.

Das Substrat hat auf jeden Fall eine niedrigere Temperatur wie die des Vorratsbehälters. Der Metalldampf soll sich möglichst nur darauf haftend niederschlagen. Damit der Dampfniederschlag bzw. der Niederschlag aus der Zerstäubungswolke so kleinflächig wie möglich bleibt, rotiert der Substrathalter in der horizontalen Bohrung des Blocks unter links- und rechtsseitig kleiner, vollkommener Schlitzbildung, so dass von dem Substrathalter allenfalls eine Fläche, deren Projektion der Querschnittsfläche des vertikalen Durchgangsbereichs gleich ist, freiliegt.

Der Substrathalter stößt mit seine beiden Stirnflächen, den Gleitlagerringen bei axialer Bewegung an der dem Lagergehäuse übergestülpten, topfförmigen Heizung an, so dass er dadurch bei Drehung zwar axial positioniert bleibt, aber spielen kann. Zum Stecken und Ziehen der Antriebswelle für die Substrathalterdrehung ist die übergestülpte Heizung im Achsbereich für diese frei durchgängig.

Die Heizung hat auf der oberen Stirnseite eine zentrale Öffnung, in die der vertikale Durchgangsbereich völlig mündet. Diese Öffnung weitet sich nach außen hin und steht der darüber aufgestellten Zerstäubungseinrichtung gegenüber, so dass die Zerstäubungs- oder Sputterwolke als gerichteter Materialstrom ungehindert in den Durchgangsbereich gelangen kann.

Die geometrische Baugröße der Anlage und die Zusammensetzung der Dünnschicht auf einem eingelegten Substrat wird beispielhaft unten beschrieben.

Die Anlage zur Beschichtung eines Substrats mit einer mehrkomponentigen Schicht besteht durch diese Bauweise aus einer abgeschlossenen Metalldampfquelle für die Komponente mit dem Hohen/höchsten Dampfdruck, einem definiert drehbaren rotationssymmetrischen Substrathalter und der darüber stehenden Zerstäubungsquelle für die hoch/höher siedende Komponente mit niedrigem/niedrigerem Dampfdruck. Durch diesen Aufbau sind beide Quellen räumlich nahezu hermetisch voneinander getrennt. Durch die Abgeschlossenheit des Innenraums der Metalldampfquelle und die Aufrechterhaltung der Temperatur über der Metallsiedetemperatur kann ein brauchbar hoher Dampfdruck erzeugt und aufrechterhalten sowie der Niederschlag darin unterdrückt werden. Der Metalldampf entweicht nur durch den oder die Kanäle zum Substrat hin und schlägt sich nicht unkontrolliert und damit funktionsstörend nieder. Durch diese Maßnahmen besteht eine sichere Langzeitfunktion.

Eine beispielhafte Ausführung des Substrathalters wird im folgenden anhand der Zeichnung vorgestellt. Es zeigt:

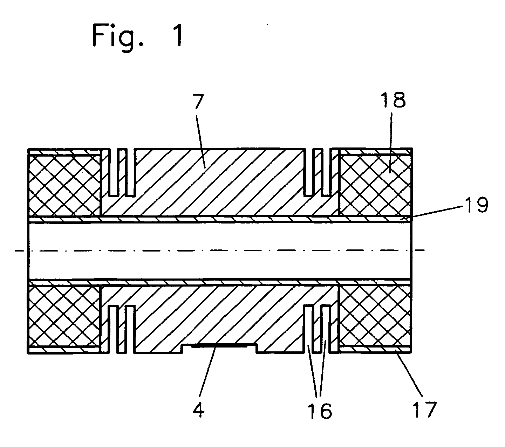

Figur 1 den Substrathalter im axialen Schnitt,

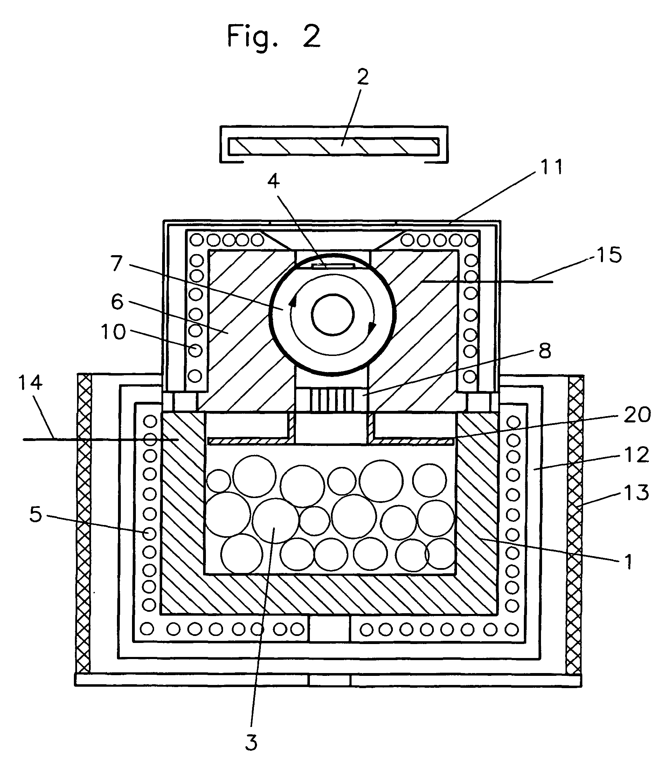

Figur 2 die Anlage mit eingebautem Substrathalter.

Die ebene Ausnehmung für die Substrateinlage in dem Substrathalter 7 aus Edelstahl hat eine Rechteckausdehnung von etwa 12 mm x 20 mm. Die übrigen Konturen lassen sich daraus linear abgreifen. Das Substrat 4 ist ein Saphirblättchen, das mit Silberlot auf der kreissehnenebenen Ausnehmung angeklebt ist. Auf diesem Substrat 4 wird eine Bor-Magnesium-Dünnschicht abgeschieden. Magnesium ist die Komponente mit dem hohen Dampfdruck und wird deshalb in der Dampfquelle 1 verdampft. Bor ist die Komponente mit dem niedrigen Dampfdruck. Es wird deshalb über die Zerstäubungseinrichtung 2 ein atomarer Teilchenstrom erzeugt, der auf die Exponierungsposition des Substrats für diese Komponente gerichtet ist.

In den topfförmigen Vorratsbehälter 1 aus Edelstahl wird festes Mg-Granulat gegeben. Die Außenwände des Vorratsbehälters 1 umgibt die elektrische Heizung 5 zum Verdampfen des in den Vorratsbehälter 1 geschütteten Mg-Granulats, der bei 650°C thermostatisiert wird.

Zum oberen Teil gehört die becherförmige Heizung 10 für den Substrathalter 7 die von dem Abschirmbecher 11 aus Edelstahl mit Öffnung zum Bor-Sputtertarget 2 umgeben ist. Die Heizung 10 wird über das massive Gehäuse 6 aus Edelstahl, den Block/das Lagergehäuse oder die Lagerung, für den Substrathalter 7, gestülpt, in dem sich die zwei temperaturbeständigen, ringförmigen, keramischen Lager 18 aus Al₂O₃ zur Aufnahme des zylinderförmigen drehbaren Substrathalters 7 gleitend drehen. Das Substrat 4 ist für die Beschichtung auf der achsparallelen, kreissehnenebenen Ausnehmung/Ausfräsung auf dem Zylindermantel mit Leitsilber aufgeklebt. Die Rotation des Substrathalters 7 wird über seine Hohlwelle mit ihrer Stirn eingesteckte, nicht eingezeichnete Antriebswelle angetrieben. Die Antriebswelle ist beispielsweise über eine magnetische Drehdurchführung mit einem regel- und steuerbaren Elektromotor gekoppelt.

Der auf der Welle des Substrathalters sitzende Körper ist hier über eine radial durchgehende Schraube mit der hohlen Welle zueinander nicht verrückbar gekoppelt. Gleichzeitig geht die Schraube durch die Welle hindurch und bildet so im lichten Bereich die Ankoppeleinrichtung für die Antriebswelle, die an ihrer Stirn einen Schlitz hat, die Einrastvorrichtung.

Die Erwärmung des Substrathalters 7 und des Substrats 4 erfolgt vornehmlich über die Wärmestrahlung des Lagergehäuses 6, das durch die Wärmestrahlung der aufgestülpten Heizkappe 10 erhitzt/aufgeheizt und hier bei 500°C thermostatisiert wird.

Der oder die Kanäle 8 für den Durchtritt des Magnesiumdampfes aus der Dampfquelle 1 in den vertikalen Durchgangsbereich des Lagergehäuses ist eine Austrittsbohrung oder sind Austrittsbohrungen mit hier einem Durchmesser von ≈ 1 mm.

Der Spalt zwischen rotierendem Substrathalter 7 und Lagergehäuse 6 beträgt nur ca. 0,1 mm und ist so eng, dass allenfalls nur verschwindend wenig Mg-Dampf durch die Öffnung in den Abschirmbecher 11 entweicht.

Das auf der zentralen, ebenen Ausnehmung des Substrathalters 7 mit Silberlot angeklebte Saphirsubstrat 4 hat eine Betriebstemperatur für die Beschichtung von Tₛ = 500°C und wird wechselweise dem Mg-Dampf, Exposition nach unten, und dem durch Absputtern feinen, gerichteten Bor-Atom-Strahl/-Fluss, Exposition nach oben, ausgesetzt, so dass beide Komponenten auf der Substratoberfläche zu der gewünschten Verbindung MgB₂ miteinander reagieren.

Bei den angegebenen Substrattemperaturen ist die Mg-Abdampfrate der MgB₂-Schicht so gering, dass die Schichtoberfläche, während sie nur der B-Quelle 2 zugewandt ist, nicht im richtigen Verhältnis, 1Mg : 2B, mit durch Abdampfen von Mg reagiert. Dies gilt für Rotationsfrequenzen im Bereich von 1 Hz. Da die Mg-Dampfquelle nahezu abgeschlossen ist, wird selbst bei einer Verdampfertemperatur Tᵥ von 650°C das B-Target im Betrieb nicht mit einer Mg-Schicht überzogen.

Durch die zuvor beschriebene neue Einrichtung und den angepassten Beschichtungsprozess gelingt es, die Verdampfertemperatur über 530°C hinaus auf 650°C zu erhöhen, ohne dass das Bor-Target 2 mit Mg bedeckt wird. Durch die damit verbundene Erhöhung des Mg-Dampfdruckes kann die Substrattemperatur Tₛ von 440 bis auf 500°C erhöht werden.

### Bezugszeichenliste

- 1.: Vorratsbehälter
- 2.: Zerstäubungseinrichtung, Sputtereinrichtung
- 3.: Komponente, Granulat
- 4.: Substrat
- 5.: Heizung
- 6.: Block, Lagergehäuse
- 7.: Substrathalter
- 8.: Kanal, Austrittsbohrung
- 9.: Schild, Deckel
- 10.: Heizung
- 11.: Abschirmbecher, Wärmeschild
- 12.: Abschirmbecher, Wärmeschild
- 13.: Abschirmrohr
- 14.: Thermoelement
- 15.: Thermoelement
- 16.: Einstich
- 17.: Lagerring
- 18.: Gleitlagerring
- 19.: Welle
- 20.: Scheibe

## Patentansprüche

1. Drehbarer Substrathalter, gelagert in einer Einrichtung zum Beschichten eines Substrats mit einer mehrkomponentigen, metallischen Dünnschicht unter Vakuumbedingungen,
wobei:
der Substrathalter (7) aus einer Welle aus mindestens bis 800°C wärmebeständigem und gut wärmeleitendem Material besteht,
auf der Welle koaxial ein kreiszylindrischer Körper aus demselben Material lösbar, mittig festsitzt,
der Körper an seinen beiden Endbereichen koaxial je mindestens einen ringscheibenförmigen Einstich (16) hat,
der Körper an seiner Mantelwand eine achsparallele, kreissehnenebene Ausnehmung für die Aufnahme und Exposition des zu beschichtenden Substrats (4) hat, die durch Drehung des Substrathalters (7) kontinuierlich von der völligen Exposition zur Dampfquelle (1) über die völlige Verdeckung zur völligen Exposition zur Zerstäubungseinrichtung (2) über die völlige Verdeckung zum Anfang drehbar ist,
der Körper außerhalb der Exponierpositionen seiner ebenen Ausnehmung zumindest im Bereich der Einstiche (16) völlig von seinem Lagerkörper (6) in der Beschichtungseinrichtung berührungslos unter Spaltbildung umgeben ist,
an den beiden Stirnflächen des Körpers je ein ringförmiges Gleitringlager (18) aus wärmebeständigem, schlecht wärmeleitendem Material gleitfähig anliegt, das auf der Welle mit seiner inneren Mantelfläche und mit seiner äußeren Mantelfläche am Lagerkörper (6) gleitet und hierzu an seiner äußeren Mantelwand und/oder an seiner inneren Mantelwand ein bis auf eine schlitzartige Durchtrennung umlaufendes Band aus demselben Material wie die Welle des Substrathalters oder seines Lagerkörpers lösbar anliegen hat, dessen beide, gegenüberstehende Stirnflächen sich bei der höchsten Betriebstemperatur gerade noch nicht berühren.

2. Drehbarer Substrathalter nach Anspruch 1, **dadurch gekennzeichnet, dass** das die beiden Ringe (18) aus einem wärmebeständigen Glas oder aus einer wärmebeständigen Keramik sind.

3. Drehbarer Substrathalter nach Anspruch 2, **dadurch gekennzeichnet, dass** die Welle hohl ist, von der Innenwand der kreiszylindrischen Hülse ein Stift radial nach innen ragt oder ein Stift über die lichte Weite sitzt, an welchem eine herangeführte Antriebeswelle mit ihrer Stirn eingreifen kann.

4. Drehbarer Substrathalter nach Anspruch 3, **dadurch gekennzeichnet, dass** die Welle massiv ist und zumindest an einer Stirnseite eine Struktur für einen Eingriff einer herangeführten Antriebswelle hat.

## Claims

1. Rotatable substrate holder mounted in a plant for coating a substrate with a multi-component, metal thin layer under vacuum conditions, with:
the substrate holder (7) consisting of a shaft made of a material with a thermal resistance up to 800°C at least and a good thermal conductivity,
a cylinder of the same material fixed coaxially and in a detachable manner in the center of the shaft,
both cylinder ends provided coaxially with at least one annular groove (16),
the cylinder wall provided with a recess along the circle chord and parallel to the cylinder axis for taking up and exposure of the substrate to be coated (4) and this recess being rotated continuously from complete exposure to the vapor source (1) to complete coverage to complete exposure to the spraying system (2) to complete coverage to the start by the rotation of the substrate holder (7),
the cylinder, except for the exposure positions in its plane recess, in the area of the grooves (16) at least, being enclosed completely by its support (6) in a contact-free manner with a gap in-between,
both cylinder ends being in sliding contact with an annular sliding bearing (18) made of a heat-resistant material of bad thermal conductivity, which slides on the shaft with its inner surface and on the support (6) with its outer surface and the outer surface and/or inner surface for this purpose being enclosed by a slotted ring (17) made of the same material as the shaft of the substrate holder or its support, the opposite ends of the ring being just not in contact with each other at the highest operation temperature.

2. Rotatable substrate holder as claimed in Claim 1, with both rings (18) being made of a heat-resistant glass or a heat-resistant ceramic material.

3. Rotatable substrate holder as claimed in Claim 2, with the shaft being hollow and a pin protruding radially into the inside from the inner wall of the cylindrical sleeve or a pin being located above the clearance, with which the end of the approaching driving shaft can engage.

4. Rotatable substrate holder as claimed in Claim 3, with the shaft being massive and at least one end of the shaft being provided with a structure for engagement with the approaching driving shaft.

## Revendications

1. Support de substrat orientable, monté dans un dispositif servant à revêtir sous vide un substrat d'une couche mince métallique à plusieurs composants,
où
le support de substrat (7) est constitué d'un arbre d'un matériau résistant à la chaleur jusqu'au moins 800°C et bien thermoconducteur,
un corps cylindrique circulaire, amovible et centré, du même matériau, étant calé coaxialement sur l'arbre,
le corps possédant coaxialement sur chacune de ses deux extrémités au moins une entaille en forme de disque circulaire (16),
le corps possédant, sur la paroi de son enveloppe, un creux paraxial, plan par rapport à la corde de cercle, pour la réception et l'exposition du substrat à revêtir (4) qui est orientable en continu en tournant le support de substrat (7), depuis l'exposition totale à la source de vapeur (1), en passant par la couverture complète pour l'exposition totale par rapport au dispositif de vaporisation (2), en revenant à la couverture totale, au point de départ,
à l'extérieur des positions d'exposition de son creux plan, du moins dans la zone des entailles (16), le corps étant complètement entouré de son palier (6) dans le dispositif de revêtement, sans contact et formant une fente,
sur chacune des deux surfaces frontales du corps, un pallier annulaire à bague de glissement (18) en matériau résistant à la chaleur et de mauvaise conductibilité thermique adhère d'une manière frottante, qui glisse sur l'arbre, le long du corps de palier (6), par sa surface d'enveloppe intérieure et sa surface d'enveloppe extérieur, et sur lequel, à cet effet, adhère d'une manière amovible, sur sa paroi d'enveloppe extérieure et/ou sa paroi d'enveloppe intérieure, une bande périphérique à l'exception d'une coupe en fente, constituée du même matériau que le support de substrat et son corps de palier, dont les deux surfaces frontales opposées qui tout juste ne se touchent pas à la température maximale de fonctionnement.

2. Support de substrat orientable selon la revendication 1, **caractérisé en ce que** les deux bagues (18) sont en verre réfractaire ou en céramique réfractaire.

3. Support de substrat orientable selon la revendication 2, **caractérisé en ce que** l'arbre est creux, qu'à partir de la paroi intérieure du fourreau cylindrique circulaire, une broche dépasse vers l'intérieur ou qu'une broche est logée sur la diamètre intérieur, et dans lequel un arbre de commande approché peut s'engrener par son front.

4. Support de substrat orientable selon la revendication 3, **caractérisé en ce que** l'arbre est massif et qu'il possède du moins sur une face frontale d'une structure permettant l'engrènement d'un arbre de commande approché.
